Europäisches Patentamt

European Patent Office

Office européen des brevets

(11) Veröffentlichungsnummer: **0 560 148 A1**

## EUROPÄISCHE PATENTANMELDUNG

(21) Anmeldenummer: **93103111.6**

(22) Anmeldetag: **26.02.93**

(51) Int. Cl.5: **G01R 1/22**, G01R 15/02, G01R 35/00

(30) Priorität: **09.03.92 DE 4207442**

(43) Veröffentlichungstag der Anmeldung:
**15.09.93 Patentblatt 93/37**

(84) Benannte Vertragsstaaten:
**BE CH DE ES FR GB IT LI NL SE**

(71) Anmelder: **SIEMENS AKTIENGESELLSCHAFT**
**Wittelsbacherplatz 2**
**D-80312 München(DE)**

(72) Erfinder: **Brunswick, Joachim, Dipl.-Ing.**
**Friedhofstrasse 6**
**W-8756 Kahl(DE)**

(54) **Strommesszange und Verfahren zum Kalibrieren derselben.**

(57) Der Strommeßzange (2) ist eine Einrichtung (30) zur Kalibrierung zugeordnet. Diese umfaßt bevorzugt ein in der Zangenschließöffnung (10) angeordnetes Kalibrierkabel (14), das über ein Strommeßgerät (32) und eine Kalibriertaste (34) mit einer Konstantstromquelle (38) in Reihe geschaltet ist. Wird die Kalibriertaste (34) betätigt, so fließt durch das Kalibrierkabel (14) ein vorgegebener Kalibrierstrom ($I_K$).Der von der Meßeinrichtung (24) angezeigte Meßstrom ($I_M'$) wird mit dem Kalibrierstrom ($I_K$) verglichen, und bei einer Abweichung der beiden Werte wird die Strommeßzange (2) auf das Vorhandensein eines Luftspalts (16) oder anderer Fehlerursachen kontrolliert, und die Meßanzeige wird korrigiert.

FIG 2

EP 0 560 148 A1

Die Erfindung bezieht sich auf eine Strommeßzange. Sie bezieht sich weiterhin auf ein Verfahren zum Kalibrieren einer Strommeßzange, die zur Messung des Stroms in einem Verbraucherkabel vorgesehen ist.

Strommeßzangen sind an sich bekannt. Sie sind im Handel erhältlich. Es gibt sie zur Messung von Wechselstrom; dann beruhen sie in der Regel auf einem induktiven Meßverfahren. Es gibt sie auch zur Messung von Gleichstrom; dann bedienen sie sich in der Regel einer Hall-Sonde. Vorliegend werden in erster Linie Strommeßzangen für die Wechselstrommessung betrachtet.

In der Praxis hat sich nun gezeigt, daß Meßfehler auftreten können. Diese sind häufig auf einen kleinen Luftspalt zwischen den beiden Hälften der Strommeßzange zurückzuführen. Mit anderen Worten, im Betrieb ist nicht immer gewährleistet, daß die beiden Hälften nach dem Umschließen einer Ader eines zu messenden Anschlußkabels eng aufeinander liegen. Ein Luftspalt von nur 0,1 mm kann z. B. bereits einen Fehler von bis zu 15 % in der Meßanzeige hervorrufen.

Aufgabe der vorliegenden Erfindung ist es, eine Strommeßzange so auszurüsten, daß ein solcher Luftspaltfehler erkannt werden kann. Weiterhin liegt der Erfindung die Aufgabe zugrunde, ein Verfahren zum schnellen Kalibrieren einer Strommeßzange auch während des Meßeinsatzes anzugeben.

Die erstgenannte Aufgabe wird erfindungsgemäß bei einer Strommeßzange durch eine Einrichtung zur Kalibrierung gelöst. Diese Einrichtung zur Kalibrierung kann dabei insbesondere eine Konstantstromquelle umfassen, die an ein Kalibrierkabel anschaltbar ist, das durch die Zangenschließöffnung hindurchführbar ist. Bevorzugt ist vorgesehen, daß die Kalibrier-Einrichtung mit der Strommeßzange körperlich integriert ist, beispielsweise im Handgriff. Alternativ kann die Kalibrier-Einrichtung mit einem kurzen Verbindungskabel in der Nähe der Strommeßzange untergebracht sein.

Zur Lösung der zweitgenannten Aufgabe ist ein Verfahren zum Kalibrieren einer Strommeßzange, die zur Messung des Stroms in einem Verbraucher vorgesehen ist, erfindungsgemäß dadurch gekennzeichnet,

a) daß die Strommeßzange mit ihrer Zangenschließöffnung um das stromlose Verbraucherkabel und um ein Kalibrierkabel gelegt wird,

b) daß dem Kalibrierkabel ein vorgegebener Kalibrierstrom aufgeschaltet wird, und

c) daß der Kalibrierstrom mit dem von der Meßeinrichtung angezeigten Sekundärstrom verglichen wird.

Bei einer Abweichung zwischen Kalibrierstrom und Sekundärstrom wird danach die richtige Anbringung der Strommeßzange kontrolliert, und ein eventueller Luftspalt wird beseitigt.

Ausführungsbeispiele der Erfindung werden im folgenden anhand von zwei Figuren näher erläutert. Es zeigen:

Figur 1 eine Strommeßzange im Blick auf die Seite und

Figur 2 eine perspektivisch dargestellte Strommeßzange mit Meßeinrichtung und Einrichtung zur Kalibrierung am Zuleitungskabel eines Verbrauchers.

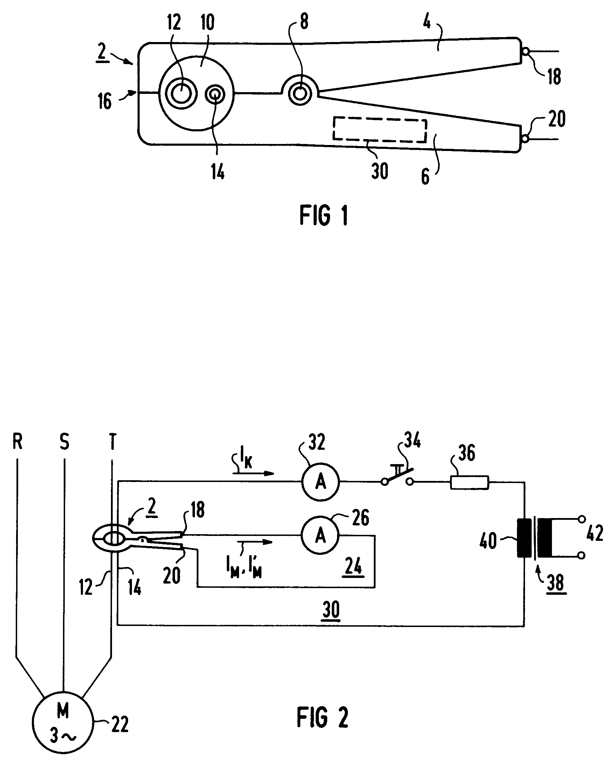

Nach Figur 1 umfaßt eine Strommeßzange 2 zwei Hälften 4, 6, die an einer Drehachse 8 zusammengefaßt sind. Die Strommeßzange 2 umfaßt weiterhin eine Zangenschließöffnung 10 kreisrunden oder angenähert kreisförmigen Querschnitts, in der sich - parallel zueinander - ein Verbraucherkabel 12 und ein Kalibrierkabel 14 befinden. Mittels des Kalibrierkabels 14 und einer im folgenden näher erläuterten Einrichtung zur Kalibrierung kann festgestellt werden, ob eine Meßabweichung vorliegt und ob sich somit zum Beispiel ein Luftspalt 16 zwischen den beiden Hälften 4 und 6 befindet. Die elektrischen Anschlüsse für die Strommeßzange 2, die zu einer konventionellen Meßeinrichtung führen, sind mit 18 und 20 bezeichnet.

Bei dem Verbraucherkabel 12 kann es sich um die Anschlußader eines elektrischen Drehstrom- oder Wechselstromverbrauchers handeln, also beispielsweise um die Phase T eines Drehstrom-Motors 22, wie er in Figur 2 dargestellt ist. Die beiden anderen Phasen sind mit R und S bezeichnet.

Nach Figur 2 ist die Strommeßzange 2 mit ihren Anschlüssen 18, 20 an eine Meßeinrichtung 24 angeschlossen, die im wesentlichen ein Anzeigegerät 26 in Form eines Strommeßgeräts umfaßt. Im Betrieb des Motors 22 wird mit diesem Anzeigegerät 26 der in der Phase T fließende Meßstrom $I_M$ angezeigt. Vorliegend wird das Anzeigegerät 26 mit Hilfe einer Einrichtung 30 zur Kalibrierung kalibriert, und das Vorhandensein eines eventuell vorhandenen Luftspalts 16 oder einer anderen Fehlerursache kann vor der eigentlichen Strommessung erkannt werden. Nach Beseitigung dieses Luftspalts 16 oder der anderen Fehlerursache ist sichergestellt, daß das Anzeigegerät 26 im Sekundärkreis der Strommeßzange 2 richtig anzeigt.

Die Einrichtung 30 zur Kalibrierung umfaßt das bereits erwähnte Kalibrierkabel 14, das durch die Zangenschließöffnung 10 geführt ist. Mit ihm in Reihe geschaltet ist ein Prüfgerät oder Strommeßgerät 32, das in Reihe liegt zu einer Kalibriertaste 34, einem Begrenzungswiderstand 36 und einer Konstantstromquelle 38 in Form eines Stromtransformators 40, der primärseitig an eine Spannungsversorgung 42, insbesondere an das übliche Netz von 220 V und 50 Hz, angeschlossen ist. Die Einrichtung 30 zur Kalibrierung steht beim Meßeinsatz unmittelbar am Ort der Strommessung zur Verfügung. Dazu kann sie bevorzugt in einen Handgriff der Strommeßzange 2 eingebaut sein, was in Figur 1 durch einen gestrichelten Block 30 angedeutet ist. Alternativ kann sie auch über ein kurzes Verbindungskabel mit dem eigentlichen Kalibrierkabel 14 verbunden und gegebenenfalls auch in die Meßeinrichtung 24 integriert sein.

Bei der Strommessung mittels der Strommeßzange 2 mit Eigenkalibrierung gemäß Figur 2 werden bevorzugt die folgenden Verfahrensschritte durchgeführt:

a) Der Verbraucher, vorliegend also der Motor 22, wird stromlos geschaltet.

b) Sodann wird die Strommeßzange 2 um das Verbraucherkabel 12, vorliegend also um die Phase T der Ader des Anschlußkabels des Motors 22, gelegt.

c) Anschließend wird über die Kalibriertaste 34 ein vorgegebener Wechselstrom $I_K$ im Kalibrierkabel 14 eingeschaltet. Dieser führt infolge induktiver Wechselwirkung zu einem Sekundärstrom $I_M'$ in der Strommeßzange 2.

d) Sodann wird der Wert des Kalibrierstroms $I_K$ mit dem Sekundärstrom $I_M'$ der Strommeßzange 2 verglichen. Bei Abweichung der beiden Werte voneinander kann ein Luftspaltfehler oder ein anderer Fehler vorliegen. Daher wird dann vor allem die richtige Anbringung der Strommeßzange 2 kontrolliert. Der gefundene Fehler wird korrigiert, damit auch die Meßanzeige. Bei Übereinstimmung der beiden Werte ist die Meßeinrichtung 24 meßbereit.

e) Nunmehr kann - bei gelöster Kalibriertaste 34 - der Verbraucher 22 eingeschaltet und der Strom in der Phase T richtig gemessen werden.

**Patentansprüche**

1. Strommeßzange (2), **gekennzeichnet** durch eine Einrichtung (30) zur Kalibrierung derselben.

2. Strommeßzange nach Anspruch 1, **dadurch gekennzeichnet,** daß die Einrichtung (30) zur Kalibrierung eine Konstantstromquelle (38) umfaßt, die an ein Kalibrierkabel (14) anschaltbar ist, das durch die Zangenschließöffnung (10) hindurchführbar ist.

3. Strommeßzange nach Anspruch 2, **dadurch gekennzeichnet,** daß die Einrichtung (30) zur Kalibrierung ein Strommeßgerät (32) umfaßt, dessen Anzeige mit der Anzeige der Meßeinrichtung (24) vergleichbar ist.

4. Strommeßzange nach Anspruch 2 oder 3, **dadurch gekennzeichnet,** daß die Einrichtung (30) zur Kalibrierung eine von Hand zu betätigende Kalibriertaste (32) umfaßt.

5. Strommeßzange nach einem der Ansprüche 2 bis 4, **dadurch gekennzeichnet,** daß die Konstantstromquelle (38) einen Stromtransformator (40) und bevorzugt einen Begrenzungswiderstand (36) umfaßt.

6. Strommeßzange nach einem der Ansprüche 1 bis 5, **dadurch gekennzeichnet,** daß die Einrichtung (30) zur Kalibrierung in die Meßeinrichtung (24) oder in dem Handgriff integriert ist.

7. Verfahren zum Kalibrieren einer Strommeßzange (2), die zur Messung des Stroms ($I_M$) in einem Verbraucherkabel (12) vorgesehen ist, **dadurch gekennzeichnet,**

a) daß die Strommeßzange (2) mit ihrer Zangenschließöffnung (10) um das stromlose Verbraucherkabel (12) und um ein Kalibrierkabel (14) gelegt wird,

b) daß dem Kalibrierkabel (14) ein vorgegebener Kalibrierstrom ($I_K$) aufgeschaltet wird, und

c) daß der Kalibrierstrom ($I_K$) mit dem von der Meßeinrichtung (24) angezeigten Sekundärstrom ($I_M'$) verglichen wird.

8. Verfahren nach Anspruch 7, **dadurch gekennzeichnet,** daß bei einer Abweichung zwischen Kalibrierstrom ($I_K$) und Sekundärstrom ($I_M'$) die richtige Anbringung der Strommeßzange (2) kontrolliert und ein eventueller Luftspaltfehler korrigiert wird.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-2 228 337 (DIEHL)<br>* Seite 5, Zeile 6 - Zeile 15; Anspruch 1; Abbildung 1 *<br>--- | 1,7 | G01R1/22<br>G01R15/02<br>G01R35/00 |
| A | WO-A-8 706 352 (MÜLLER UND WEIGERT)<br>* Seite 11, Zeile 21 - Seite 12, Zeile 21; Abbildung *<br>--- | 1,7 | |
| A | DE-B-2 735 054 (SIEMENS)<br>* Spalte 3, Zeile 24 - Spalte 4, Zeile 2; Abbildung *<br><br>----- | 1,7 | |
| | | | **RECHERCHIERTE SACHGEBIETE (Int. Cl.5)**<br><br>G01R |

Der vorliegende Recherchenbericht wurde für alle Patentansprüche erstellt

| Recherchenort | Abschlußdatum der Recherche | Prüfer |
|---|---|---|
| BERLIN | 18 MAI 1993 | KEMPEN P. |